# EUROPEAN PATENT APPLICATION

(11) **EP 4 199 667 A1**
(43) Date of publication of application: **21.06.2023**
(21) Application number: 21465575.5
(22) Date of filing: 17.12.2021
(51) Int. Cl.: H05K 7/20

(54) **POWER ELECTRONICS DEVICE AND METHOD FOR MANUFACTURING A COOLING SYSTEM FOR A POWER ELECTRONICS DEVICE**

(71) Applicant: Vitesco Technologies GmbH, 93055 Regensburg (DE)
(72) Inventor: Samson, Cristinel, 81737 München (DE); Murgoci, Dragos, 81737 München (DE)
(74) Representative: Vitesco Technologies

(57) **Abstract**

Power electronics device comprising,
- a housing;
- at least one power electronic component arranged in the housing and being in thermal contact with the housing;
- at least one cooling pipe (10) being arranged at least partly inside the housing to guide a liquid coolant through the housing, the cooling pipe (10) having a longitudinal axis L;
wherein at least one turbulator (1) is arranged inside the cooling pipe (10) along the longitudinal axis L, the turbulator (1) comprising a number of wing elements (3, 3') extending radially in the cooling pipe (10), the wing elements (3, 3') being supported by a longitudinal support structure (2) and being arranged consecutively in longitudinal direction;
wherein the least one turbulator (1) is an inserting part.

## Description

Power electronics device and method for manufacturing a cooling system for a power electronics device

The present invention relates to a power electronics device, in particular for an electric vehicle. Furthermore, it relates to a method for manufacturing a cooling system for a power electronics device.

Power electronics devices for electric vehicles, for example voltage converters, inverters or on-board chargers, comprise power electronic components which generate a considerable amount of heat when in operation due to losses. This heat is dissipated by heatsinks and eventually transferred to a housing, typically a metal die-cast housing, which may comprise a cooling system. The cooling system may comprise one or more channels to guide a liquid coolant through the housing.

The coolant channel may be provided by at least one cooling pipe which is arranged at least partly inside the housing. In order to maximise the heat dissipation, the heat transfer from the power electronic components to the housing and from the housing to the liquid coolant can be optimised.

It is an object of the present invention to provide a power electronics device with an improved heat transfer to the liquid coolant. Furthermore, a method for manufacturing a cooling system for a power electronics device with an improved heat transfer to the liquid coolant shall be provided.

This object is achieved by means of the power electronics device according to claim 1 and the method for manufacturing a cooling system for a power electronics device according to claim 12.

Advantageous embodiments and developments are objects of the dependent claims.

According to an aspect of the invention, a power electronics device is provided comprising a housing and at least one power electronic component arranged inside the housing and being in thermal contact with the housing. The housing is in particular formed of a metal, for example in a metal die-cast process.

The power electronics device further comprises at least one cooling pipe arranged at least partly inside the housing to guide a liquid coolant through the housing. The cooling pipe has a longitudinal axis. The longitudinal axis may be bent, if e.g. the cooling pipe is not straight but bends in a U-shape or any meandering shape.

At least one turbulator is arranged inside the cooling pipe along the longitudinal axis, the turbulator comprising a number of wing elements extending radially in the cooling pipe, the wing elements being supported by a longitudinal support structure and being arranged consecutively in longitudinal direction. The least one turbulator is an inserting part which is inserted into the cooling pipe.

The least one turbulator can be made of an elastic material like a metal. In this case, the least one turbulator is elastically bendable along its longitudinal axis. When inserting into the cooling pipe, the least one turbulator can bend following the shaped form of the cooling pipe.

The at least one turbulator does not necessarily extend over the whole length of the cooling pipe. In particular, the at least one turbulator may be arranged in one or more straight sections of the cooling pipe.

The power electronics device may be a voltage converter, an inverter, an on-board charger or another power electronics device for an electric vehicle.

The power electronics device has the advantage that the at least one turbulator considerably enhances the transfer of heat from the material of the cooling pipe to the liquid coolant by introducing turbulences in the otherwise laminar flow of the coolant. A more turbulent flow, i.e. a flow with a higher Reynold's number, improves the heat transfer coefficient (HTC). Thus, the power electronics device has an improved heat dissipation through the liquid cooling system.

According to the invention, the turbulator comprises a longitudinal support structure. The longitudinal axis of the structure may be congruent with the longitudinal axis of the cooling pipe. The support structure, which may be a central structure extending along the longitudinal axis, or which may extend along an outer surface of the turbulator, holds the wing elements in place.

According to an embodiment, the wing elements are arranged in groups, each group consisting of a number of wing elements arranged at the same level with respect to the longitudinal axis and rotationally symmetrical with respect to the longitudinal axis.

According to this embodiment, the groups are arranged consecutively in longitudinal direction and each wing element of a group extends radially at the same level with respect to the longitudinal axis. In other words, the groups of wing elements are stacked along the longitudinal axis and spaced apart from each other. This embodiment has the advantage that it may be easy to manufacture and provides a flow path for turbulent flow, while the flow resistance may be relatively low.

The wing elements of a group may be separated by flow gaps. According to this embodiment, the wing elements of one group may form a disc with certain gaps, the flow gaps. Flow gaps between the wing elements provide a path for the liquid coolant.

According to an embodiment, consecutive wing elements are arranged rotated against each other with respect to the longitudinal axis. This embodiment has the advantage that fluid may not flow unimpeded through flow gaps which are arranged consecutively along the length of the turbulator in a straight line. Instead, the fluid is forced to change its flow direction between consecutive wing elements. Hence, a meandering flow path is forced which introduces turbulences into the flow.

Depending on the width of the wing elements and on the angle by which consecutive wing elements are arranged rotated against each other, a flow gap in a group of wing elements may be completely obstructed by a wing element of the consecutive group. However, such an arrangement may cause a considerable pressure drop in the liquid coolant. Therefore, it may be preferable to choose an arrangement where flow gaps are arranged at least partially consecutively along the length of the turbulator. In other words, the angle, by which a subsequent wing element is rotated may be smaller than the angle covered by the flow gap.

According to an embodiment, the wing elements and the longitudinal support structure of the turbulator are formed in one piece. This has the advantage that the turbulator is easy to manufacture and to introduce into the cooling pipe.

The at least one turbulator may be molded of a plastic material or formed from sheet metal.

According to an embodiment, the longitudinal support structure is arranged in the centre of the cooling pipe and thus forms the centre of the turbulator. Alternatively or additionally, the longitudinal support structure may be arranged on an inner surface of the cooling pipe and thus form the outside of the turbulator. The design of the turbulator and its longitudinal support structure are largely dependent on the way of manufacturing. While a turbulator made from sheet metal by punching wing elements and bending them in a way that they protrude from the plane of the metal sheet and by subsequently bending the metal sheet into a tube, which fits into the cooling pipe, a longitudinal support structure arranged on an inner surface of the cooling pipe is produced. On the other hand, a turbulator produced in a molding process from plastic material may be of a different design and have a longitudinal support structure arranged in the centre for higher flexibility.

It may be advantageous to arrange several turbulators in a cooling pipe. The cooling pipe may consist of several straight sections connected to each other by a bent section. A turbulator may be arranged in each of the straight sections.

According to an aspect of the invention, a method for manufacturing a cooling system for a power electronics device is provided. The method comprises providing a cooling pipe with a longitudinal axis and providing at least one turbulator, the turbulator comprising a number of wing elements extending radially and being supported by a longitudinal support structure and being arranged consecutively in longitudinal direction. The turbulator may be formed according to the embodiments described above. The method further comprises inserting the at least one turbulator into the cooling pipe before or after the pipe is mounted inside the housing of a power electronics device.

The method has the advantage that the turbulator may be manufactured at low cost by a standard process independently from the manufacturing of the cooling pipe and/or the housing.

Embodiments of the present invention are described with reference to schematic figures.
- Figure 1: shows a first view of a turbulator according to a first embodiment of the invention,
- Figure 2: shows a second view of the turbulator according to figure 1,
- Figure 3: shows a third view of the turbulator according to figure 1,
- Figure 4: shows a first view of a turbulator according to a second embodiment of the invention,
- Figure 5: shows a second view of the turbulator according to figure 4,
- Figure 6: shows a third view of the turbulator according to figure 4,
- Figure 7: shows a first view of a cooling pipe with two turbulators, and
- Figure 8: shows a second view of the cooling pipe according to figure 7.

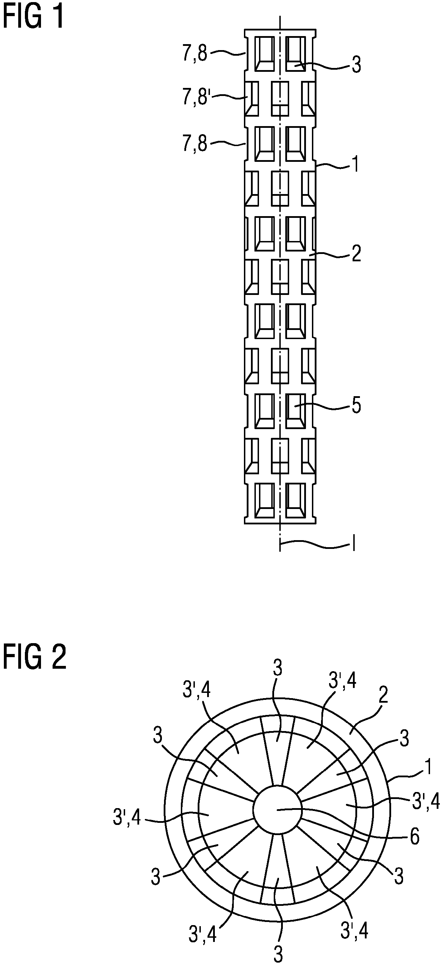

Figures 1 to 3 show different views of a turbulator 1 according to a first embodiment of the invention. The turbulator 1 comprises a longitudinal support structure 2 and a number of wing elements 3 extending radially inwards from the longitudinal support structure 2.

The wing elements 3 are arranged in levels 7 with respect to the longitudinal axis I of the turbulator 1. The wing elements 3 of one level 7 form a group 8.

The wing elements 3 are separated from each other by flow gaps 4. A central gap 6 is formed along the longitudinal axis I of the turbulator 1.

The turbulator 1 according to figures 1 to 3 is formed from a metal sheet which is punched to form triangular wing elements 3 which are subsequently bent to protrude from the plane of the metal sheet. Thus, openings 5 in the metal sheet are formed. Subsequently, the metal sheet is bent to form a tube 9 with the wing elements 3 extending inwardly and with the central gap 6 extending along the longitudinal axis I of the tube 9. The outer diameter of the tube 9 may be equal to the inner diameter of a cooling pipe which is intended to receive the turbulator 1. Furthermore, the tube 9 and the wing elements 3 are formed integrally as a single piece.

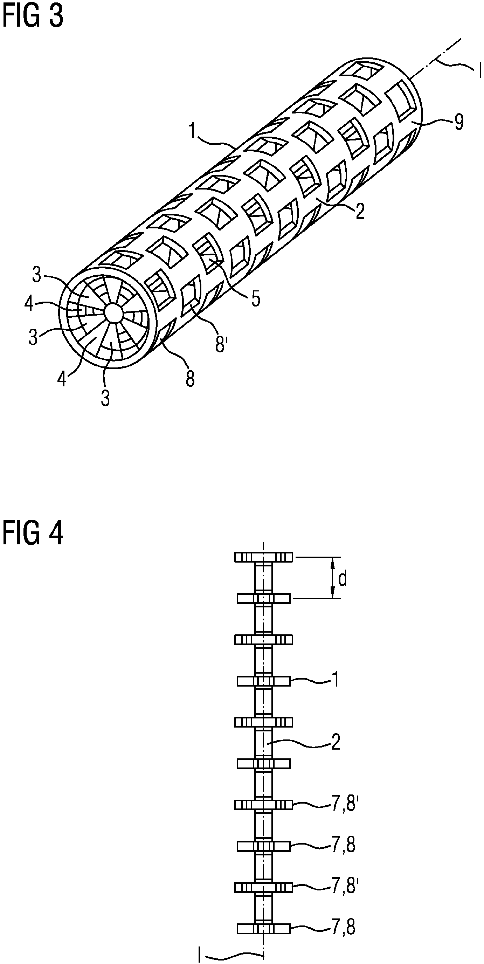

Figures 4 to 6 show views of a turbulator 1 according to a second embodiment of the invention. The turbulator 1 according to figures 4 to 6 is formed in a molding process from a plastic material. It comprises groups 8 of wing elements 3 arranged consecutively along the longitudinal axis I of the turbulator 1. The wing elements 3 of each group 8 are spaced apart by flow gaps 4. The groups 8 of wing elements 3 are spaced apart by a distance d.

According to this embodiment, each group 8 of wing elements 3 is formed by a disc with openings forming the flow gaps 4 and the discs are stacked along the longitudinal axis I and connected by the longitudinal support structure 2. The longitudinal support structure 2 and all of the wing elements 3 are formed integrally as a single piece.

Groups 8 of consecutive wing elements 3 are arranged rotated against each other with respect to the longitudinal axis I. According to the embodiment shown in figures 1 to 3, groups with a first orientation are denoted by the reference number 8, while groups with a second orientation are denoted by the reference number 8'. Hence, wing elements of a group 8 are denoted by reference numbers 3, while wing elements of a group 8' are denoted by reference numbers 3'. According to the embodiment shown in figures 1 to 3, the groups 8 of wing elements 3 are rotated by about 39° with respect to the preceding and the subsequent groups 8'.

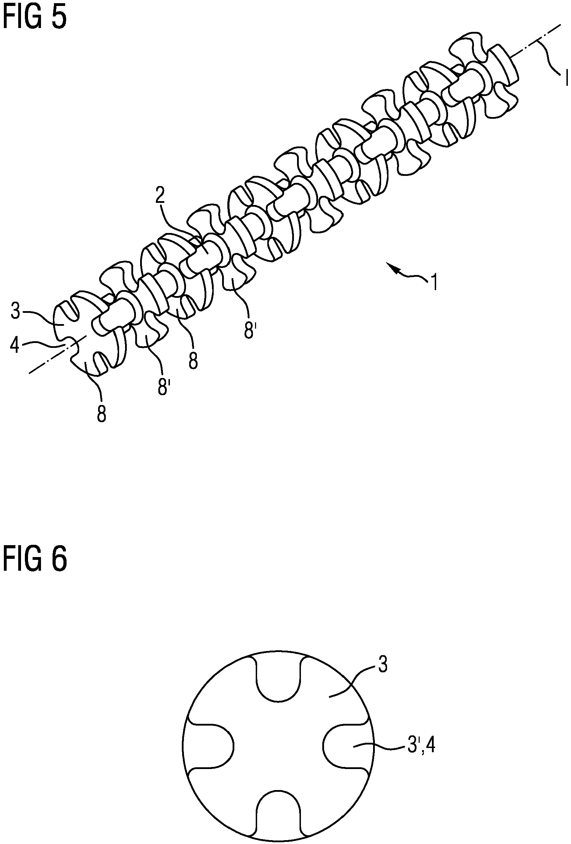

Likewise, according to the embodiment shown in figures 4 to 6, the discs forming the groups 8 of wing elements 3 are rotated by 90° with respect to the preceding and the subsequent groups 8'. In figure 5, groups with a first orientation are denoted by the reference number 8, while groups with a second orientation are denoted by the reference number 8'.

This arrangement of consecutive groups 8, 8' has the advantage of inducing a highly turbulent flow in the liquid coolant. An unimpeded flow of coolant through the cooling pipe is not possible, because there is no unimpeded flow path through the turbulator 1, since a flow gap 4 between wing elements 3 of one group 8 is followed by a wing element 3' of the subsequent group 8' and vice versa.

In case the pressure drop along the tabulator 1 of figures 4 to 6 is larger than can be tolerated, the angle of the orientation of consecutive groups 8, 8' may be lower than 45°, leaving a partially unimpeded flow path through the turbulator 1. According to an embodiment not shown in the figures, the angle of rotation might be 30 to 60°.

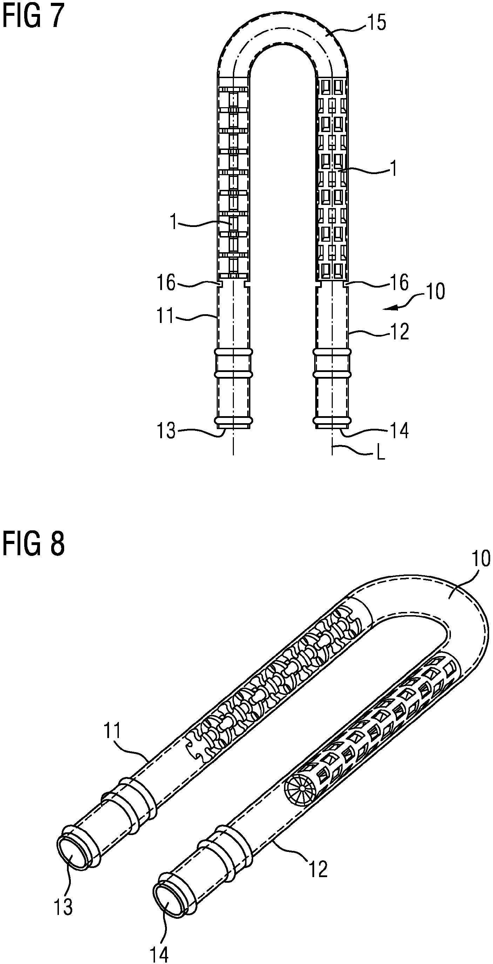

Figures 7 and 8 show different views of a u-shaped cooling pipe 10 with a first branch 11 and a second branch 12 connected by a bent portion 15. The cooling pipe 10 comprises a longitudinal axis L and an inlet 13 into the first branch 11 and an outlet 14 of the second branch 12. The cooling pipe 10 is intended to be arranged inside the housing of a power electronics device in contact with the housing. In operation, a liquid coolant flows through the cooling pipe 10 from the inlet 13 through the first branch 11, the bent part 15 and the second branch 12 to the outlet 14 and is heated up by the heat transferred from the housing to the cooling pipe 10.

In the first branch 11 and in the second branch 12, which are not bent, but have a straight shape, turbulators 1 are arranged to enhance heat transfer from the cooling pipe 10 to the liquid coolant. In the embodiment shown in figure 7 and 8, different types of turbulators 1 are arranged in the branches 11, 12. However, the same type of turbulator 1 can be chosen for both branches 11, 12.

The turbulators 1 of both above described embodiments according to figures 1 to 3 and figures 4 to 6 are formed as an inserting part which is inserted into the cooling pipe 10. The turbulators 1 of both above described embodiments are elastically bendable along its longitudinal axis I. When inserting into the cooling pipe 10, the turbulators 1 can bend following the shaped form of the cooling pipe 1.

The turbulators 1 may be kept in place by providing indentations 16 (shown only in figure 7) in the cooling pipe 10 in the region of the end of the turbulators 1 facing towards the inlet 13 and the outlet 14, respectively. The indentations 16 may be provided by a crimping tool after the turbulators 1 are inserted into the cooling pipe 10. The indentations 16 may be provided e.g. in several separate points or in a continuous beading.

### List of reference symbols

- 1: turbulator
- 2: longitudinal support structure
- 3, 3': wing element
- 4: flow gap
- 5: opening
- 6: central gap
- 7: level
- 8, 8': group
- 9: tube
- 10: cooling pipe
- 11: first branch
- 12: second branch
- 13: inlet
- 14: outlet
- 15: bent portion
- 16: indentation

- I: longitudinal axis of the turbulator
- L: longitudinal axis of the cooling pipe

## Claims

1. Power electronics device comprising,
- a housing;
- at least one power electronic component arranged in the housing and being in thermal contact with the housing;
- at least one cooling pipe (10) being arranged at least partly inside the housing to guide a liquid coolant through the housing, the cooling pipe (10) having a longitudinal axis L;
wherein at least one turbulator (1) is arranged inside the cooling pipe (10) along the longitudinal axis L, the turbulator (1) comprising a number of wing elements (3, 3') extending radially in the cooling pipe (10), the wing elements (3,3') being supported by a longitudinal support structure (2) and being arranged consecutively in longitudinal direction;
wherein the least one turbulator (1) is an inserting part.

2. Power electronics device according to claim 1,
wherein the wing elements (3, 3') are arranged in groups (8, 8'), each group (8, 8') consisting of a number of wing elements (3, 3') arranged at the same level (7) and rotationally symmetrical with respect to a longitudinal axis I of the turbulator (1).

3. Power electronics device according to claim 2,
wherein the wing elements (3, 3') of a group (8, 8') are separated by flow gaps (4).

4. Power electronics device according to any of claims 1 to 3,
wherein consecutive wing elements (3, 3') are arranged rotated against each other with respect to the longitudinal axis I.

5. Power electronics device according to any of claims 1 to 4,
wherein the wing elements (3, 3') and the longitudinal support structure (2) of the turbulator (1) are formed in one piece.

6. Power electronics device according to any of claims 1 to 5,
wherein the at least one turbulator (1) is molded of a plastic material.

7. Power electronics device according to any of claims 1 to 5,
wherein the at least one turbulator (1) is formed from sheet metal.

8. Power electronics device according to any of claims 1 to 7,
wherein the longitudinal support structure (2) is arranged in the centre of the cooling pipe (10).

9. Power electronics device according to any of claims 1 to 8,
wherein the longitudinal support structure (2) is arranged on an inner surface of the cooling pipe (10).

10. Power electronics device according to any of claims 1 to 9,
wherein several turbulators (1) are arranged in the cooling pipe (10).

11. Power electronics device according to any of claims 1 to 10,
wherein the housing is a metal die-cast housing.

12. Method for manufacturing a cooling system for a power electronics device, the method comprising
- providing a cooling pipe (10) with a longitudinal axis L;
- providing at least one turbulator (1), the turbulator (1) comprising a number of wing elements (3, 3') extending radially and being supported by a longitudinal support structure (2) and being arranged consecutively in longitudinal direction;
- inserting the at least one turbulator (1) into the cooling pipe (10).
